# EUROPEAN PATENT SPECIFICATION

(11) **EP 4 079 712 B1**
(45) Date of publication and mention of the grant of the patent: **21.05.2025**
(21) Application number: 21779538.4
(22) Date of filing: 29.03.2021
(51) Int. Cl.: C04B 37/02, H05K 3/38, H05K 1/02, H05K 1/03

(54) **CIRCUIT BOARD, JOINED BODY, AND METHODS FOR PRODUCING SAME**
LEITERPLATTE, VERBUNDENER KÖRPER UND VERFAHREN ZU DEREN HERSTELLUNG
CARTE DE CIRCUIT IMPRIMÉ, CORPS ASSEMBLÉ ET LEURS PROCÉDÉS DE PRODUCTION

(30) Priority: 30.03.2020 JP 2020060861
(43) Date of publication of application: 26.10.2022
(73) Proprietor: Denka Company Limited, Tokyo 103-8338 (JP)
(72) Inventor: YUASA, Akimasa, Tokyo 103-8338 (JP); NAKAMURA, Takahiro, Tokyo 103-8338 (JP); ESHIMA, Yoshiyuki, Tokyo 103-8338 (JP); KOBASHI, Seiji, Tokyo 103-8338 (JP); NISHIMURA, Koji, Tokyo 103-8338 (JP)
(74) Representative: Hoffmann Eitle
(86) International application number: PCT/JP2021/013392
(87) International publication number: WO 2021/200866

(56) References cited:
- EP-A1- 2 727 898
- WO-A1-2013/094213
- WO-A1-2013/094213
- WO-A1-2018/221492
- WO-A1-2018/221493
- WO-A1-2019/022133
- JP-A- 2005 051 066
- JP-A- 2005 051 066
- JP-A- 2005 252 087
- JP-A- 2008 044 009
- JP-A- 2015 030 658
- JP-A- H10 251 075
- US-A1- 2016 221 305

## Description

### Technical Field

The present disclosure relates to circuit boards, joined bodies, and methods for producing same.

### Background Art

With an increase in performance of industrial equipment such as robots and motors, amount of heat generated from semiconductor elements mounted on power modules has been increasing. In order to efficiently dissipate the heat, circuit boards including a ceramic substrate having good thermal conductivity are used. In such a circuit board, thermal stress is generated due to heating and cooling processes during joining of the ceramic substrate and a metal plate and due to heat cycles during use. Accordingly, cracks may be generated in the ceramic substrate or the metal plate may be peeled off.

A technique for improving reliability by relaxing thermal stress generated in a ceramic circuit board has been studied. For example, in Patent Document 1, it is studied to improve the heat cycle resistance by setting the average size and the number density of the Cu-rich phase of the brazing layer within predetermined ranges. Patent Document 2 proposes forming an Ag-rich phase along a joining interface between a ceramic substrate and a circuit pattern.

### Citation List

### Patent Literature

[Patent Document 1] PCT International Publication No. WO2018/221492
[Patent Document 2] PCT International Publication No. WO2019/022133

Document JP2005051066 discloses an AIN board that is brazed to a copper plate using a brazing that contains 90 mass parts of Ag, 10 mass parts of copper powders, 3 mass parts of titanium powder and 2 mass parts of zirconium powder.

EP2727898 discloses a brazing material for bonding between a ceramic substrate and a metal plate, the brazing material being a powder mixture provided by mixing an alloy powder comprising at least 55 to 80 mass% of Ag, 1 to 5 mass% of In, and the balance Ct with inevitable impurities. An active metal hydride powder is also added.

US2016221305 discloses a Cu/ceramic bonded body formed by bonding a copper member and a ceramic member made of AIN or Al₂O₃ using a bonding material containing Ag and Ti.

### Summary of Invention

### Technical Problem

Circuit boards are required to be sufficiently excellent in reliability depending on the use thereof. For example, in the field of power modules such as drive units of trains and electric vehicles, it is required to maintain excellent reliability even under severe conditions of heat cycles. This is because, for example, when the cooling temperature is lowered, tensile stress generated in the ceramic substrate is increased and cracks are easily generated in the ceramic substrate. Accordingly, the present disclosure provides a circuit board having excellent heat cycle resistance and a producing method thereof. In addition, the present disclosure provides a joined body having excellent heat cycle resistance and a producing method thereof.

### Solution to Problem

The joined body and the method of producing a joined body according to the present invention are defined in the appended claims.

A circuit board according to one aspect of the present disclosure is a circuit board in which a ceramic substrate (in the present case, a silicon nitride substrate) and a metal circuit board (in the present case, a copper circuit board) are joined together with a Ag-Cu-Sn-based brazing layer containing silver, and a mean value of a KAM value of a silver portion in the brazing layer obtained by EBSP method is 0.55° or less.

Here, the KAM (Kernel Average Misorientation) value indicates an orientation difference between adjacent measurement points in a crystal grain, and is obtained by crystal orientation analysis using EBSP (Electron Back Scattering Pattern) method. It can be said that the smaller the KAM value is, the smaller the strain of the crystal is.

Since the ceramic substrate and the metal circuit board have significantly different linear thermal expansion coefficients, residual stress is generated in a joint between the ceramic substrate and the metal circuit board due to a difference from temperature during joining. The residual stress appears as strain of the crystal structure of the component contained in the brazing layer. When the residual stress becomes large, cracks are likely to be generated in the ceramic substrate, and heat cycle resistance is impaired. In the circuit board of the present disclosure, since the mean value of the KAM value of the silver portion in the brazing layer is sufficiently small, the residual stress in the joint between the ceramic substrate and the metal circuit board is sufficiently reduced. Accordingly, the circuit board of the present disclosure has excellent heat cycle resistance.

The metal circuit board is a copper circuit board. A mean value of a KAM value of copper contained in the copper circuit board obtained by the EBSP method may be 0.36° or less. Accordingly, the residual stress in the joint of the circuit board can be sufficiently reduced, and heat cycle resistance can be further improved.

The brazing layer of the circuit board may include an exposed part exposed from an edge of the metal circuit board. In this case, the mean value of the length L of the exposed part may be 20 µm or more, and the mean value of the thickness T of the exposed part may be 4 to 30 µm. Accordingly, stress concentration in the joint can be sufficiently reduced, and heat cycle resistance can be further improved.

A joined body according to one aspect of the present disclosure is a joined body in which a ceramic substrate (in the present case, a silicon nitride substrate) and a metal plate (in the present case, a copper plate) are joined together with a brazing layer containing silver, and a mean value of a KAM value of a silver portion in the brazing layer obtained by EBSP method is 0.55° or less.

Since the ceramic substrate and the metal plate have significantly different linear thermal expansion coefficients, residual stress is generated in a joint between the ceramic substrate and the metal plate due to a difference from temperature during joining. The residual stress appears as strain of the crystal structure of the component contained in the brazing layer. When the residual stress becomes large, cracks are likely to appear in the ceramic substrate, and heat cycle resistance is impaired. In the joined body of the present disclosure, since the mean value of the KAM value of the silver portion in the brazing layer is sufficiently small, the residual stress in the joint between the ceramic substrate and the metal plate is sufficiently reduced. Accordingly, the joined body of the present disclosure has excellent heat cycle resistance. By using such a joined body, a circuit board having excellent heat cycle resistance can be obtained.

The metal plate is a copper plate. The mean value of a KAM value of copper contained in the copper plate obtained by the EBSP method may be 0.36° or less. Accordingly, residual stress in the joint of the joined body can be sufficiently reduced, and heat cycle resistance can be further improved.

The content of silver in the brazing layer of the joined body is 85% or more by mass or more, and the mean value of a thickness T of the brazing layer may be 4 to 30 µm. Accordingly, it is possible to further improve heat cycle resistance by sufficiently reducing stress generated in the joint while achieving miniaturization and thinning.

A method for producing a joined body according to an aspect of the present disclosure includes: applying a brazing material containing silver to a main surface of a silicon nitride substrate; laminating the silicon nitride substrate and a copper plate with interposing the brazing material therebetween to obtain a multilayer body; firing the multilayer body at a firing temperature of 750°C or higher for 10 minutes or longer; and annealing the fired multilayer body at a temperature of 550°C or higher and lower than 750°C for 10 minutes or longer.

In the producing method, the multilayer body is held at a firing temperature of 750°C or higher for 10 minutes or longer to be fired, and then the fired multilayer body is held at 550°C or higher and lower than 750°C for 10 minutes or more to be annealed. In general, when the ceramic substrate is sintered at a sintering temperature of 750°C or higher and cooled to room temperature, a large residual stress is generated in the joint of the joined body due to a difference in linear thermal expansion coefficient between the ceramic substrate and the metal plate. However, in the above-described producing method, since annealing is performed at a temperature of 550°C or higher and lower than 750°C for 10 minutes or longer, the residual stress of the joint can be reduced. Accordingly, residual stress in the joint is sufficiently reduced, and a joined body having excellent heat cycle resistance can be produced.

In the producing method, the multilayer body may be held at a firing temperature of 750°C or higher for shorter than 3 hours, and may be cooled from the firing temperature to less than 750° C at a cooling rate of 1°C/min or more. Accordingly, producing efficiency can be improved, and diffusion of silver contained in the brazing material into the metal plate can be prevented. Thus, the heat cycle characteristics can be improved.

In the joined body obtained by annealing, a ceramic substrate and a copper plate as the metal plate are joined together with a brazing layer containing silver, a mean value of a KAM value of a silver portion in the brazing layer obtained by the EBSP method is 0.55° or less, and a mean value of a KAM value of copper contained in the copper plate obtained by the EBSP method may be 0.36° or less. In such a joined body, since the mean value of the KAM value of the silver portion in the brazing layer and the copper contained in the copper plate are sufficiently small, the residual stress in the joint between the ceramic substrate and the metal plate is sufficiently reduced. Accordingly, the heat cycle resistance is sufficiently excellent.

A producing method of a circuit board according to an aspect of the present disclosure includes removing a part of a metal plate in a joined body obtained by the above-described producing method to form a metal circuit board, thereby obtaining a circuit board. Since the circuit board obtained in this manner uses the joined body described above, residual stress in the joint between the ceramic substrate and the metal circuit board is sufficiently reduced. Therefore, heat cycle resistance is excellent.

The brazing layer of the circuit board obtained by the producing method may have an exposed part exposed from an edge of the metal circuit board. In this case, the mean value of the length L of the exposed part may be 20 µm or more, and the mean value of the thickness T of the brazing layer may be 4 µm to 30 µm. Accordingly, it is possible to further improve heat cycle resistance by sufficiently reducing stress generated in the joint while achieving miniaturization and thinning.

### Advantageous Effects of Invention

According to the present disclosure, it is possible to provide a circuit board having excellent heat cycle resistance and a producing method thereof. In addition, it is possible to provide a joined body having excellent heat cycle resistance and a producing method thereof. Such a circuit board and a joined body can be suitably used in, for example, a power module.

### Brief Description of Drawings

FIG. 1 is a plan view of a circuit board according to an embodiment.
FIG. 2 is a cross-sectional view taken along line II-II of FIG. 1.
FIG. 3 is a perspective view of a joined body according to one embodiment.
FIG. 4 is a cross-sectional view taken along line IV-IV of FIG. 3.

### Description of Embodiments

Hereinafter, an embodiment of the present disclosure will be described with reference to the drawings in some cases. However, the following embodiments are examples for describing the present disclosure, and are not intended to limit the present disclosure to the following contents. In the description, the same elements or elements having the same functions are denoted by the same reference numerals, and redundant description is omitted in some cases. In addition, positional relationships such as up, down, left, and right are based on positional relationships illustrated in the drawings unless otherwise specified. Further, the dimensional ratio of each element is not limited to the illustrated ratio.

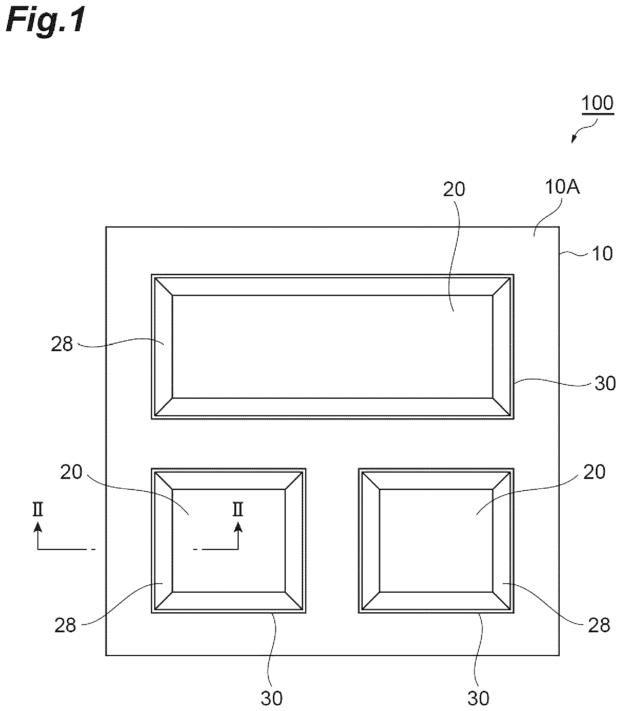

FIG. 1 is a plan view of the circuit board of the present embodiment. A circuit board 100 comprises a ceramic substrate 10 and three metal circuit boards 20 joined to a main surface 10A of the ceramic substrate 10. The ceramic substrate 10 and the metal circuit board 20 are joined together with a brazing layer 30 interposed therebetween. The edge of the brazing layer 30 is exposed along the outer edge of the metal circuit board 20.

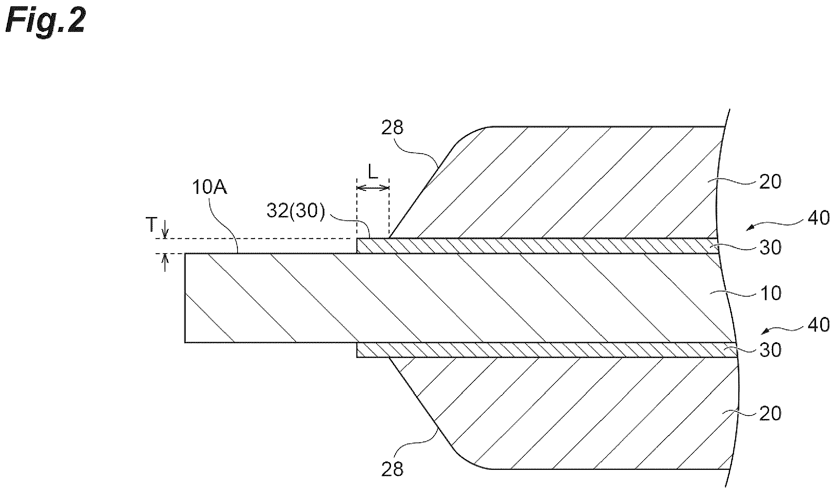

FIG. 2 is a cross-sectional view taken along line II-II of FIG. 1. FIG. 2 illustrates a part of a cross section of the circuit board 100 when cut along a plane perpendicular to main surfaces 10A and 10B of the ceramic substrate 10. Each joint 40 between the ceramic substrate 10 and a pair of the metal circuit board 20 includes the brazing layer 30.

The material of the ceramic substrate 10 is silicon nitride from the viewpoint of mechanical strength and fracture toughness.

The thickness of the ceramic substrate 10 may be, for example, 0.1 to 3 mm, 0.2 to 1.2 mm, or 0.25 to 1.0 mm. The thickness of the metal circuit board 20 may be, for example, 0.1 to 1.5 mm.

The brazing layer 30 is formed of an Ag-Cu-Sn-based brazing material containing silver, copper, tin, and an active metal contained as TiH₂. The content of silver in the brazing layer 30 is 85% by mass or more. This makes it possible to improve denseness of the brazing layer 30 while sufficiently reducing the residual stress in the joint 40.

The active metal in the brazing layer 30 is 1 to 5 parts by mass with respect to 100 parts by mass of the total of silver and copper. By setting the content of the active metals to 1 parts by mass or more, the joinability between the ceramic substrate 10 and the brazing layer 30 can be improved. By setting the content of the active metal to 5 parts by mass or less, it is possible to prevent formation of a brittle alloy layer at the joining interface. The active metal is titanium hydride (TiH₂). The content of TiH₂ in the brazing layer 30 is 1 to 5 parts by mass with respect to 100 parts by mass of the total of silver and copper. Accordingly, the joining strength between the ceramic substrate 10 and the metal circuit board 20 can be sufficiently increased.

The amount of tin in the brazing layer 30 is 0.5 to 5 parts by mass with respect to 100 parts by mass of the total of silver and copper. Accordingly, both the effect of reducing residual stress and the wettability of the brazing material with respect to the ceramic substrate 10 can be achieved at a high level. The content of Cu in the brazing layer 30 may be 5 to 20 parts by mass with respect to 100 parts by mass of silver. This makes it possible to improve the denseness of the brazing layer 30 while sufficiently reducing the residual stress in the joint 40.

The mean value of a KAM (Kernel Average Misorientation) value of the silver portion in the brazing layer 30 is 0.55° or less. From the viewpoint of further reducing residual stress in the joint 40, the mean value of the KAM value may be 0.53° or less, and may be 0.4° or less. The KAM value of the silver portion may be 0.01° or more, 0.05° or more, 0.10° or more, 0.20° or more, or 0.30° or more. Accordingly, the annealing time during producing can be shortened.

The KAM value is a value indicating an orientation difference between adjacent measurement points in a crystal grain of a silver portion, and is obtained by EBSP (Electron Back Scattering Pattern) method using a commercially available OIM (Orientation Imaging Microscopy) crystal orientation analysis device. The orientation difference in the crystal grain may be measured by using analysis software attached to the OIM crystal orientation analysis device. The mean value of the KAM values of the silver portion is obtained as an arithmetic mean value of measured values obtained by performing measurement at five points of the brazing layer 30. When a component other than silver is included in each measurement field of view, the silver portion and the portion of the other component are separated by energy dispersive X-ray analysis (EDS), and the mean value of the KAM value of the silver portion is obtained. The "silver portion" in the present disclosure refers to a region of the brazing layer where silver is detected by EDS.

The metal circuit board 20 is a copper circuit board from the viewpoint of improving electrical conductivity and heat dissipation. A mean value of the KAM value of copper contained in the copper circuit board may be 0.36° or less, and may be 0.35° or less. Accordingly, the residual stress in the joint 40 can be further reduced. The mean value of the KAM value of copper may be 0.01° or more, 0.05° or more, 0.10° or more, 0.20° or more, or 0.30° or more. Accordingly, annealing time during producing can be shortened. The mean value of the KAM value of copper can be determined in the same manner as the mean value of the KAM value of silver portion in the brazing layer 30.

The thickness of the metal circuit board 20 may be 0.1 to 1.5mm. From the viewpoint of improving heat dissipation properties, the thickness of the metal circuit board 20 may be 0. 3mm or more, and may be 0.4mm or more. A side part 28 of the metal circuit board 20 may be formed to expand as it approaches the ceramic substrate 10 as illustrated in FIG. 2. However, the shape of the side part of the metal circuit board 20 is not limited to the shape in FIG. 2.

The edge of the brazing layer 30 is exposed at outer edge portion of the metal circuit board 20. In the present disclosure, the edge of the brazing layer 30 that protrudes from the metal circuit board 20 without being covered by the metal circuit board 20 is referred to as an exposed part 32. It is not essential to have the exposed part 32, but by having the exposed part 32, the concentration of stresses occurring in the joint 40 can be reduced. Accordingly, heat cycle resistance may be further improved.

The mean values of the thickness T and the length L of the exposed part 32 are arithmetic mean values of measured values of the thickness T and the length L measured at five arbitrarily selected places (five visual fields) of the exposed part 32, respectively. The mean value of the length L of the exposed part 32 may be 20 µm or more, and may be 30 µm or more. The residual stress caused by the difference in linear thermal expansion coefficient between the ceramic substrate 10 and the metal circuit board 20 tends to be concentrated on the outer edge of the metal circuit board 20. Accordingly, when the mean value of the length L of the exposed part 32 is within the above-described range, the concentration of residual stress is alleviated, and heat cycle resistance can be further improved. From the viewpoint of reducing the size of the circuit board 100, the mean value of the length L of the exposed part 32 may be 150 µm or less, 100 µm or less, 75 µm or less, or 50 µm or less.

The mean value of the thickness T of the exposed part 32 may be 4 to 30 µm, 6 to 20 µm, or 6 to 15 µm. This makes it possible to sufficiently increase the joining strength in the joint 40. The mean value of the thickness T of the exposed part 32 is the same as the mean value of the thickness of the brazing layer 30 between the ceramic substrate 10 and the metal circuit board 20. However, in a modification, the mean value of the thickness T of the exposed part 32 may be different from the mean value of the thickness of the brazing layer 30 between the ceramic substrate 10 and the metal circuit board 20. The mean values of these thicknesses may both be within the above-described range (the range of the mean value of the thickness T). In one field of view, when the thickness T differs depending on the position of the exposed part 32, the mean value of the maximum and minimum values of the thicknesses T of the field of view is the thicknesses T of the field of view.

The metal circuit board 20 may have a plating film on a surface portion thereof. From the viewpoint of improving weather resistance and solder wettability, the plating film may be a Ni plating film, a Ni alloy plating film, or a gold plating film. The Ni plating film may be an electroless Ni plating film. The electroless Ni plating film may be a nickel-phosphorus plating film containing 1 to 12% by mass of nickel. By having such an electroless Ni-plated film, it is possible to provide the circuit board 100 having excellent heat cycle resistance and excellent solder wettability. The exposed part 32 may also have a similar plating film on its surface portion.

While only one main surface 10A of the ceramic substrate 10 is illustrated in FIG. 1, as illustrated in FIG. 2, in the ceramic substrate 10, another metal circuit board 20 is also joined to another main surface 10B with the brazing layer 30 as illustrated in FIG. 2. In a modification, a heatsink instead of the metal circuit board 20 may be joined to one of the main surface 10A and the main surface 10B with a brazing layer. In this case, the metal circuit board 20 and the heatsink may be made of the same material or may be made of different materials. The metal circuit board 20 has a function of transmitting an electric signal, whereas the heatsink may have a function of transmitting heat. However, the heatsink may have a function of transmitting an electric signal.

The brazing layer that joins the heatsink to the main surface of the ceramic substrate may have the same composition and thickness as those of the brazing layer that joins the metal circuit board. Also, in a similar manner to the brazing layer 30, an edge of the brazing layer may be exposed from an outer edge of the heatsink.

In the circuit board 100, since the mean value of the KAM value of the silver portion in the brazing layer 30 is sufficiently small, the residual stresses in the joint 40 of the ceramic substrate 10 and the metal circuit board 20 are sufficiently reduced. Therefore, the circuit board 100 has excellent heat cycle resistance. As an example, the crack rate of the circuit board 100 after the heat cycle test may be less than 1% by area, less than 0.5% by area, or less than 0.3% by area. The heat cycle test referred to herein is a test in which a series of steps of holding at -55°C for 15 minutes, at 25°C for 15 minutes, at 150°C for 15 minutes, and at 25°C for 15 minutes is taken as one cycle, and this is performed for 2000 cycles. The crack rate is the ratio of the areas of cracks to the areas of the metal circuit board 20.

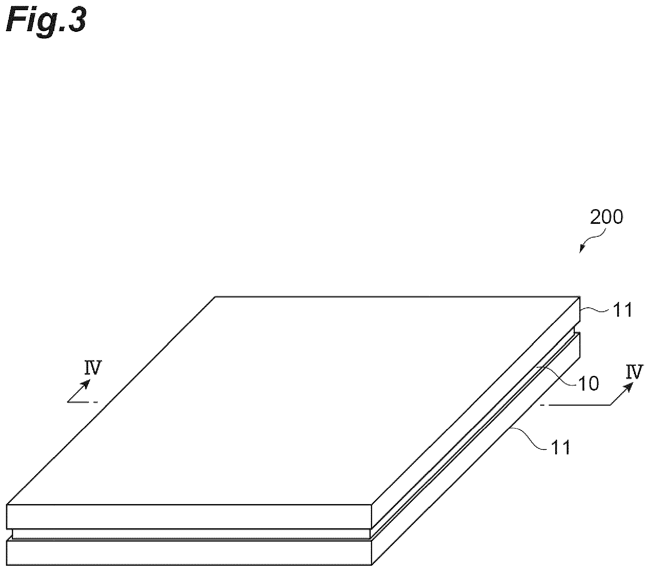

FIG. 3 is a perspective view of a joined body according to one embodiment. A joined body 200 includes a pair of metal plates 11 disposed to face each other and a ceramic substrate 10 disposed between the pair of the metal plates 11.

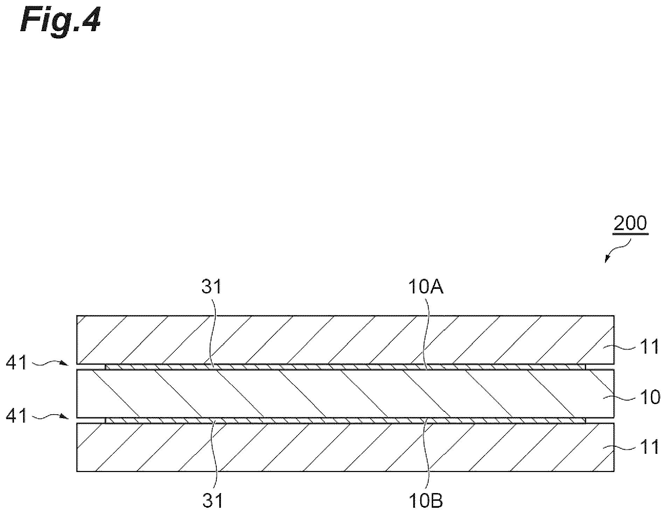

FIG. 4 is a cross-sectional view taken along line IV-IV of the joined body 200 of FIG. 3. The metal plates 11 are joined to each of the main surface 10A and the main surface 10B of the ceramic substrate 10 with a brazing layer 31. That is, the joined body 200 has two joints 41. The joined body 200 can be used as a raw material for the circuit board 100. That is, the ceramic substrate 10 in the joined body 200 may be the same composition (material), shape, and thicknesses as those of the ceramic substrate 10 in the circuit board 100. The compositions (materials) and thicknesses of the metal plates 11 and the brazing layer 31 in the joined body 200 may also be the same as those of the metal circuit boards 20 and the brazing layer 30 in the circuit board 100.

The mean value of the KAM (Kernel Average Misorientation) value of the silver portion in the brazing layer 31 constituting the joint 41 is also 0.55° or less, similarly to that in the silver portion in the brazing layer 30 of the circuit board 100. From the viewpoint of further reducing residual stress in the joint 41, the mean value of the KAM value may be 0.53° or less, and may be 0.4° or less. The mean value of the KAM value of the silver portion in the brazing layer 31 may be 0.01° or more, and may be 0.05° or more. Accordingly, annealing time during producing can be shortened. The method for obtaining the mean value of the KAM value is the same as that in the case of the silver portion in the brazing layer 30 of the circuit board 100.

The metal plate 11 is a copper plate from the viewpoint of improving electrical conductivity and heat dissipation. The mean value of the KAM value of copper contained in the copper plate may be 0.36° or less, and may be 0.35° or less. Accordingly, the residual stress in the joint 41 can be further reduced. The mean value of the KAM value of copper in the copper plate may be 0.01° or more, and may be 0.05° or more. Accordingly, annealing time during producing can be shortened. The method of obtaining the mean value of the KAM value of copper in the copper plate is the same as the case of copper included in the copper circuit board.

The metal plate 11 may be 0.1 to 1.5 mm thick. From the viewpoint of improving heat dissipation properties, it may be 0.3 mm or more, and may be 0.4 mm or more. It is not essential to provide the metal plates 11 on both of the main surface 10A and the main surface 10B of the ceramic substrate 10, and the metal plate 11 may be provided on only one main surface. When the metal plates 11 are provided on both of the main surface 10A and the main surface 10B of the ceramic substrate 10, the materials, thicknesses, shapes, and the like of the two metal plates 11 may be the same or different from each other. The brazing layer 31 may be provided entirely between the ceramic substrate 10 and the metal plate 11, or may be provided only in a portion where the metal circuit board 20 is formed.

Since the mean value of KAM value of silver portion in the brazing layer 31 in the joined body 200 is sufficiently small, residual stress in the joint 41 of the ceramic substrate 10 and the metal plate 11 is sufficiently reduced. Therefore, the joined body 200 has excellent heat cycle resistance. By using such the joined body 200, the circuit board 100 having excellent heat cycle resistance can be obtained.

An example of a method for producing a joined body and a circuit board of the present disclosure will be described. First, a step of obtaining a green sheet by molding a slurry containing an inorganic compound powder, a binder resin, a sintering aid, a plasticizer, a dispersant, a solvent, and the like is performed.

Examples of the additional inorganic compound include nitride ceramics such as aluminum nitride, oxide ceramics such as aluminum oxide and zirconium oxide, carbide ceramics such as silicon carbide, and boride ceramics such as lanthanum boride. Examples of the sintering aid include rare earth metals, alkaline earth metals, metal oxides, fluorides, chlorides, nitrates, and sulfates. These may be used alone or in combination of two or more kinds thereof. By using the sintering aid, sintering of the inorganic compound powder can be promoted. Examples of the binder resin include methyl cellulose, ethyl cellulose, polyvinyl alcohol, polyvinyl butyral, and (meth)acrylic resins.

Examples of the plasticizer include phthalic acid-based plasticizers such as purified glycerin, glycerin trioleate, diethylene glycol, and di-n-butyl phthalate; and dibasic acid-based plasticizers such as di-2-ethylhexyl sebacate. Examples of dispersing agents include poly (meth)acrylates and (meth)acrylic acid-maleate copolymers. Examples of the solvent include organic solvents such as ethanol and toluene.

Examples of the slurry molding method include a doctor blade method and an extrusion molding method. Next, a step of degreasing and sintering the green sheet obtained by molding is performed. The degreasing may be performed, for example, by heating at 400 to 800°C for 0.5 to 20 hours. Accordingly, it is possible to reduce the residual amount of organic materials (carbon) while preventing oxidation and deterioration of the inorganic compound. The sintering is performed by heating to 1700 to 1900°C in a non-oxidizing gas atmosphere such as nitrogen, argon, ammonia, or hydrogen. As a result, the ceramic substrate 10 can be obtained. If necessary, the ceramic substrate 10 may be trimmed by cutting the edge by laser processing. In addition, scribe lines may be formed in the main surface 10A and/or the main surface 10B of the ceramic substrate 10.

The above-described degreasing and sintering may be performed in a state where a plurality of green sheets are laminated. In the case where degreasing and sintering are performed in laminate state, a release layer made of a release agent may be provided between the green sheets in order to smoothly separate the base material after firing. As the release agent, for example, boron nitride (BN) can be used. The release layer may be formed, for example, by applying a slurry of boron nitride powder by a method such as spraying, brushing, roll coating, or screen printing. The number of green sheets to be laminated may be, for example, 5 to 100 and may be 10 to 70, from the viewpoint of efficiently performing mass production of the ceramic substrate and sufficiently progressing degreasing.

The ceramic substrate 10 as shown in FIG. 3 and FIG. 4 is obtained in this manner. Subsequently, a step of obtaining a joined body using the ceramic substrate 10 and a pair of the metal plate 11 is performed. In detail, first, the main surface 10A and the main surface 10B of the ceramic substrate 10 are coated with a brazing material, and a pair of the metal plates 11 are attached to the main surface 10A and the main surface 10B, respectively. The metal plate 11 may have a flat plate shape similar to that of the ceramic substrate 10.

The brazing material is applied to the main surface 10A and the main surface 10B of the ceramic substrate 10 by a method such as a roll coater method, a screen printing method, or a transfer method. The brazing material contains, for example, silver powder, copper powder, tin powder, powder of an active metal or a compound (hydride) thereof, an organic solvent, and a binder. The content of the tin powder is 0.5 to 5 parts by mass with respect to 100 parts by mass of the total of the silver powder and the copper powder. The content of the metal hydride powder is 1 to 5 parts by mass with respect to 100 parts by mass of the total of the silver powder and the copper powder. The viscosity of the brazing material may be, for example, 5 to 20Pa· s. The content of the organic solvent in the brazing material may be, for example, 5 to 25% by mass, and the content of the binder may be, for example, 2 to 15% by mass.

As the silver powder, for example, one having a specific surface area of 0.1 to 0.5 m²/g may be used. Accordingly, joinability may be improved, and uniformity of a structure of the Ag-Cu-Sn-based brazing layer may be improved. The specific surface area can be measured by a gas adsorption method. The copper powder has an effect of improving melting property of the Ag-Cu-Sn-based brazing material. The tin powder has an effect of reducing an angle of contact of the brazing material with respect to the ceramic substrate 10 and improving wettability of the brazing material.

A multilayer body is obtained by superposing the metal plates **11** on the main surface 10A and the main surface 10B of the ceramic substrate 10 coated with brazing material. Subsequently, a firing process of firing the multilayer body in a heating furnace is performed. The temperature in the furnace during firing (firing temperature) is 750°C or higher, may be 750 to 950°C, and may be 780 to 900°C. The time for holding at the firing temperature (firing time) is 10 minutes or more, and may be 15 minutes or more. The firing time may be less than 3 hours or less than 90 minutes from the viewpoint of preventing diffusion of silver into the metal plate 11.

The atmosphere in the heating furnace at the time of firing may be an inert gas such as nitride, and the firing may be performed under a reduced pressure (1.0×10⁻³ Pa or less) lower than the atmosphere pressure or may be performed under vacuum. By firing the multilayer body under such conditions, the ceramic substrate 10 and the metal plates **11** can be sufficiently joined. The heating furnace may be a continuous type in which a plurality of joined bodies are continuously produced, or may be a type in which one or more joined bodies are produced in a batch manner. The heating may be performed while pressing the multilayer body in the laminating direction.

Next, in an annealing step, annealing is performed by holding the fired multilayer body at a furnace temperature of 500°C or more and less than 750°C for 10 minutes or more. The temperature in the furnace during annealing (annealing temperature) may be 550°C or more and 700°C or less, or may be 550°C or more and 650°C or less. The annealing time may be 20 minutes or more from the viewpoint of sufficiently reducing residual stress in the joint. The annealing time may be less than 4 hours from the viewpoint of improving producing efficiency. The annealing may be performed using the same heating furnace as that used in the firing, or may be performed using a different heating furnace. The annealing may be performed in an inert gas atmosphere such as nitrogen, may be performed under a reduced pressure less than atmospheric pressure, or may be performed under vacuum.

After the firing step, the inside of the furnace may be cooled at a cooling rate of 1°C/min or more to lower the temperature to the above-described annealing temperature. Thus, the producing efficiency can be improved, and the diffusion of silver contained in the brazing material into the metal plate can be prevented. From the same viewpoint, the cooling rate may be 2°C/min or more, and may be 3°C/min or more. From the viewpoint of reducing thermal shock, the cooling rate may be less than 20°C/min.

Through the above-described steps, it is possible to obtain the joined body 200 having the ceramic plate 10 and the metal plates 11 each joined, with the brazing material 31, to the main surface 10A and the main surface 10B of the ceramic plate 10. Since this producing method has a step of annealing after firing, residual stress in the joint 41 can be reduced. Therefore, the joined body 200 having excellent heat cycle resistance can be produced.

In the case of producing a circuit board, a step of forming the metal circuit board 20 by removing part of the metal plate 11 in the joined body 200 obtained in the above-described step is performed. This step may be performed by, for example, photolithography. To be more specific, first, a photosensitive resist is printed on the main surface of the joined body 200 (the main surface of the metal plate 11). Then, a resist pattern having a predetermined shape is formed using an exposure apparatus. The resist may be a negative type or a positive type. Uncured resist is removed by, for example, washing.

After forming the resist pattern, a portion of the metal plate that is not covered with the resist pattern is removed by etching. As a result, part of the main surface 10A and the main surface 10B of the ceramic substrate 10 is exposed in this portion. Thereafter, the circuit board 100 is obtained by removing the resist pattern. The shape of the side part 28 of the metal circuit board 20 and the length L and thickness T of the exposed part 32 of the brazing layer 30 can be adjusted by changing the etching conditions or the number of times of etching.

The etching solution is not particularly limited, and examples thereof include a ferric chloride solution, a cupric chloride solution, sulfuric acid, and a hydrogen peroxide solution. When the brazing layer or the like remains on the main surface 10A and the main surface 10B of the ceramic substrate 10 after etching, these may be removed by using solutions containing at least one selected from the group consisting of ammonium halide aqueous solutions, inorganic acids such as sulfuric acid and nitric acid, and oxygenated water. The method for removing the resist pattern is not particularly limited, and may be, for example, a method of immersion in an alkaline aqueous solution.

Since the circuit board 100 obtained in this manner uses the joined body 200, residual stress in the joint 40 between the ceramic substrate 10 and the metal circuit board 20 is sufficiently reduced. That is, the mean value of KAM value of silver portion in the brazing layer 30 of the circuit board 100 and the mean value of KAM value of silver portion in the brazing layer 31 of the joined body 200 are equivalent. The mean value of the KAM value of the metal contained in the metal circuit board 20 of the circuit board 100 and the mean value of the KAM value of the metal contained in the metal plate 11 of the joined body 200 are also equivalent. Accordingly, the circuit board 100 is also excellent in heat cycle resistance, similarly to the joined body 200. Although an example of the producing method of the joined body 200 and the circuit board 100 has been described above, the producing method is not limited thereto.

Since the circuit board 100 has excellent heat cycle resistance, it may be used in, for example, a power module handling a large current.

Although the embodiments of the present disclosure have been described above, the present disclosure is not limited to the above-described embodiments. For example, as illustrated in FIG. 4, the brazing layer 31 in the joined body 200 may be formed only in a portion that becomes the metal circuit board 20 or in the portion and the vicinity thereof. It may be formed so as to cover the whole of the main surface 10A and the main surface 10B of the ceramic substrate 10. In FIG. 4, both the main surface 10A and the main surface 10B of the ceramic substrate 10 are provided with the brazing layer 31 and the metal plate 11, but in another example, only one of them may be provided with the brazing layer 31 and the metal plate 11.

### [Example]

The content of the present disclosure will be described in more detail with reference to Examples and Comparative Examples, but the present disclosure is not limited to the following Examples.

### (Example 1)

### [Production of Joined Body]

In order to prepare a brazing material, the following raw material powders were prepared.
Silver powder: Ag-HWQ (trade name) manufactured by Fukuda Metallic Foil & Powder Industry Co., Ltd., Average grain size D50: 2.5 µm, specific surface 0.4 m²/g
Copper powder: Cu-HWQ (trade name) manufactured by Fukuda Metallic Foil & Powder Industry Co., Ltd., Average grain size D50: 3.0 µm, specific surface: 0.4 m²/g
Tin powder: Sn-HPN (trade name) manufactured by Fukuda Metallic Foil & Powder Industry Co., Ltd., Average grain size D50: 3 µm, specific surface: 0.1 m²/g
Titanium hydride powder: TCH-100 (trade name) manufactured by TOHOTEC Corporation

A brazing material was prepared by blending 1 part by mass of tin powder and 3.5 parts by mass of titanium hydride powder with respect to 100 parts by mass in total of silver powder (90 parts by mass) and copper powder (10 parts by mass), and adding an organic solvent, a binder, and the like. Both main surfaces of a commercially available silicon nitride substrate (0.32 mm thick) were coated with the brazing material by a screen printing method so that the coating amount was 8 mg/cm².

Copper plates (thickness: 0.5 mm, purity: 99.60% oxygen-free copper plates (JIS H 3100, C1020)) were laminated on both main surfaces of the silicon nitride substrate to obtain a multilayer body. Using an electric furnace, in a nitrogen atmosphere, the multilayer body was heated at a furnace temperature of 860°C for 18 minutes to melt the brazing material powder and join the ceramic substrate and the metal plate (firing step). Thereafter, the temperature in the furnace was cooled to 600°C at an average cooling rate of 10°C/min. Annealing was performed in a nitrogen atmosphere at a furnace temperature of 600°C for 10 minutes (annealing step). After that, heating was stopped, and natural cooling was performed to room temperature in a nitrogen atmosphere. The average rate of temperature decrease in the furnace after the annealing step was 6°C/min. In this manner, a joined body in which the ceramic substrate and the pair of metal plates were joined together with the brazing layer was produced.

### [Measurement of KAM Value]

After embedding the joined body in a resin, the joined body was cut along the thickness direction so as to pass through the center of gravity of the joined body using a coater machine. A flat milling treatment was performed on the cross section of the joined body to obtain a sample for EBSD measurement. EBSD measurement of the cut surface was performed using OIM (Orientation Imaging Microscopy) crystal orientation analysis device manufactured by TSL Solutions, Inc. The measurement voltage was 15 kV, the working distance was 17 mm, and the sample inclination angle was 70°.

The KAM value was measured using the OIM crystal orientation analysis device at five locations for each of the brazing layer and the copper plate, with the measurement field of view being 240 µm × 160 µm and the inter-measurement distance d = 0.2 µm. For the brazing layer, the silver portion and the copper portion in the brazing layer were separated by EDS measurement, and the KAM value of the silver portion was obtained. The mean value of the KAM values of the silver portion measured at five locations was as shown in Table 1. The mean value of the KAM values of copper measured at five points on the copper plate was as shown in Table 1.

### [Production of Circuit Board]

An etching resist was printed on predetermined portions of both main surfaces of the copper plates in the joined body, a resist pattern having a predetermined shape was formed on the main surfaces of the copper plates using an exposure device, and then etching was performed using a ferric chloride solution. Further, etching was performed using a mixed solution of ammonium fluoride and hydrogen peroxide to remove a portion where the resist pattern was not formed, thereby forming a predetermined circuit pattern and an exposed part of the brazing layer along the outer edge of the circuit pattern.

Subsequently, a pretreatment by degreasing and chemical polishing was performed, and then a rust prevention treatment was performed using a benzotriazole-based compound. In this manner, a circuit board in which a ceramic substrate and a metal circuit board were joined together with a brazing layer containing silver as illustrated in FIG. 1 was obtained.

### [Measurement of Length L and Thickness T of Exposed Part]

The exposed part of the brazing layer on the circuit board was observed using a scanning electron microscope (manufactured by Hitachi High-Technologies Corporation, SU6600 type). Observation of a reflected electron image (magnification: 200 times) was performed in five visual fields (each visual field was 400 µm in length × 600 µm in width), and the length and thickness of the exposed part for each visual field were obtained. The thickness of each visual field was set to be a mean value of the maximum thickness and the minimum thickness of the exposed part. The mean values of the length L and the thickness T of five visual fields were obtained. The results are shown in Table 1.

### [Evaluation of Heat Cycle Characteristics]

The produced circuit board was subjected to a heat cycle test. Specifically, a series of steps of holding at -78°C for 5 minutes, at 25°C for 5 minutes, at 350°C for 5 minutes, and at 25°C for 5 minutes was defined as one cycle, and this cycle was repeated 15 times. Thereafter, etching was performed using a ferric chloride solution, and then etching was performed using a mixed solution of ammonium fluoride and hydrogen peroxide to remove the circuit pattern and the brazing layer.

An image of the main surface of the ceramic substrate from which the circuit pattern and the brazing layer were removed was acquired at a resolution of 600dpi ^{x} 600dpi using a scanner. The image was binarized using image analysis software GIMP2 (threshold value: 140) to calculate the area of cracks. The calculated crack area was divided by the area of the circuit pattern to obtain the crack rate. The results are shown in Table 1.

### (Example 2)

A multilayer body was obtained by the same procedure as in Example 1. A joined body in which a ceramic substrate and a pair of metal plates were joined together with a brazing layer was produced in the same manner as in Example 1 except that the conditions of the firing step and the annealing step were changed as shown in Table 2. The firing step and the annealing step were performed in a vacuum atmosphere (1.0×10⁻³ Pa or less). After the annealing step, heating was stopped, and natural cooling was performed to room temperature in a vacuum atmosphere. The average cooling rate after the annealing step was 3°C/min.

In the same procedure as in Example 1, measurement of KAM value, production of circuit board, measurement of length L and thickness T of exposed part, and evaluation of heat cycle characteristics were performed. The results are shown in Table 3.

### (Examples 3 and 4)

A multilayer body was obtained by the same procedure as in Example 1. A joined body in which a ceramic substrate and a pair of metal plates were joined together with a brazing layer was produced in the same manner as in Example 1 except that the conditions of the firing step and the annealing step were changed as shown in Table 2. After the annealing step, heating was stopped, and natural cooling was performed to room temperature in a vacuum atmosphere. The average rate of temperature decrease in the furnace after the annealing step was 6°C/min.

In the same procedure as in Example 1, measurement of KAM value, production of circuit board, measurement of length L and thickness T of exposed part, and evaluation of heat cycle characteristics were performed. The results are shown in Table 3.

### (Examples 5 and 6)

A multilayer body was obtained by the same procedure as in Example 1 except that the formulation of the brazing material was as shown in Table 1. Then, a joined body in which a ceramic substrate and a pair of metal plates were joined together with the brazing layer was produced in the same manner as in Example 1 except that the conditions of the firing step and the annealing step were changed as shown in Table 2. In Example 5, after the annealing step, heating was stopped, and natural cooling was performed to room temperature in a vacuum atmosphere (1.0×10⁻³ Pa or less). The average rate of temperature decrease in the furnace after the annealing step was 3°C/min. In Example 6, after the annealing step, heating was stopped, and natural cooling was performed to room temperature in a nitrogen atmosphere. The average rate of temperature decrease in the furnace after the annealing step was 6°C/min.

In the same procedure as in Example 1, measurement of KAM value, production of circuit board, measurement of length L and thickness T of exposed part, and evaluation of heat cycle characteristics were performed. The results are shown in Table 3.

### (Comparative Example 1)

A joined body was obtained in the same manner as in Example 1 except that the annealing step was not performed in the production of the joined body. After the firing step, the average cooling rate to room temperature was 6°C/min. In the same procedure as in Example 1, measurement of KAM value, production of circuit board, measurement of length L and thickness T of exposed part, and evaluation of heat cycle characteristics were performed. The results are shown in Table 3.

### (Comparative Example 2)

A joined body was produced by the same procedure as in Comparative Example 1 except that the formulation of the brazing material was as shown in Table 1. After the firing step, the average cooling rate to room temperature was 6°C/min. In the same procedure as in Example 1, measurement of KAM value, production of circuit board, measurement of length L and thickness T of exposed part, and evaluation of heat cycle characteristics were performed. The results are shown in Table 3.

**Table 1**

| | Formulation of Brazing Material [Mass Part] | | | |
|---|---|---|---|---|
| | Silver Powder | Copper Powder | Tin Powder | Titanium Hydride Powder |
| Example 1 | 90 | 10 | 1 | 3.5 |
| Example 2 | 90 | 10 | 1 | 3.5 |
| Example 3 | 90 | 10 | 1 | 3.5 |
| Example 4 | 90 | 10 | 1 | 3.5 |
| Example 5 | 90 | 10 | 3 | 3.5 |
| Example 6 | 90 | 10 | 3 | 3.5 |
| Comparative Example 1 | 90 | 10 | 1 | 3.5 |
| Comparative Example 2 | 90 | 10 | 3 | 3.5 |

**Table 2**

| | Furnace Temperature | Heating Time | Atmosphere | Temperature | Time | Atmosphere |
|---|---|---|---|---|---|---|
| Example 1 | 860°C | 18 minutes | Nitrogen | 600°C | 30 minutes | Nitrogen |
| Example 2 | 790°C | 60 minutes | Vacuum | 600°C | 120 minutes | Vacuum |
| Example 3 | 860°C | 18 minutes | Nitrogen | 600°C | 24 minutes | Nitrogen |
| Example 4 | 860°C | 18 minutes | Nitrogen | 600°C | 60 minutes | Nitrogen |
| Example 5 | 790°C | 60 minutes | Vacuum | 600°C | 120 minutes | Vacuum |
| Example 6 | 860°C | 18 minutes | Nitrogen | 600°C | 30 minutes | Nitrogen |
| Comparative Example 1 | 860°C | 18 minutes | Nitrogen | None | | |
| Comparative Example 2 | 860°C | 18 minutes | Nitrogen | None | | |

**Table 3**

| | Mean value of KAM value [°] | | Exposed Part [µm] | | Heat Cycle Characteristic s |
|---|---|---|---|---|---|
| | Brazing Material Layer (Silver Portion) | Copper Plate (Copper) | Mean value of Length L | Mean value of Thickness T | Crack Rate [% by area] |
| Example 1 | 0.52 | 0.34 | 33 | 8 | 0.2 |
| Example 2 | 0.44 | 0.33 | 29 | 8 | 0.2 |
| Example 3 | 0.50 | 0.34 | 30 | 8 | 0.2 |
| Example 4 | 0.32 | 0.33 | 35 | 12 | 0.1 |
| Example 5 | 0.32 | 0.35 | 25 | 6 | 0.3 |
| Example 6 | 0.53 | 0.35 | 26 | 7 | 0.3 |
| Comparative Example 1 | 0.57 | 0.37 | 32 | 9 | 1.1 |
| Comparative Example 2 | 0.58 | 0.38 | 28 | 5 | 1.3 |

As shown in Table 3, in Examples 1 to 6 in which the annealing step was performed, the crystal strains of the silver portion and the copper contained in the brazing layer and the copper plate, respectively, were smaller than those in Comparative Examples 1 and 2. As a result, it was confirmed that the crack rate could be reduced.

### Industrial Applicability

According to the present disclosure, a circuit board having excellent heat cycle resistance and a producing method thereof are provided. In addition, a joined body having excellent heat cycle resistance and a method for producing the joined body are provided.

### Reference Signs List

10: ceramic substrate, 10A, 10B: main surface, 11: metal plate, 20: metal circuit board, 28: side part, 30, 31: brazing layer, 32: exposed part, 40, 41: joint, 100: circuit board, 200: joined body.

## Claims

1. A joined body in which a silicon nitride substrate and a copper plate are joined together with a brazing layer formed of an Ag-Cu-Sn-based brazing material containing silver, copper, tin, and an active metal contained as TiH₂,
wherein the content of silver in the brazing layer is 85% by mass or more,
wherein the amount of tin in the brazing layer is 0.5 to 5 parts by mass with respect to 100 parts by mass of the total of silver and copper, wherein the content of TiH₂ in the brazing layer is 1 to 5 parts by mass with respect to 100 parts by mass of the total of silver and copper,
wherein a mean value of a KAM value of a silver portion in the brazing layer obtained by EBSP method, as described in the description, using an orientation imaging microscopy is 0.55° or less, and
wherein the KAM value is a kernel average misorientation value indicating an orientation difference between adjacent measurement points in a crystal grain, and EBSP is an electron back scattering pattern method.

2. The joined body according to claim **1,**
wherein a mean value of a KAM value of copper contained in the copper plate obtained by EBSP method is 0.36° or less.

3. The joined body according to claim 1 or 2,
wherein a mean value of a thickness T of the brazing layer is 4 to 30 µm.

4. The joined body according to according to any one of claims 1 to 3, wherein the copper plate is a copper circuit board, and
wherein the joined body is a circuit board.

5. The joined body according to claim 4, wherein the brazing layer comprises an exposed part exposed from an edge of the copper circuit board,
wherein a mean value of a length L of the exposed part is 20 µm or more, and
wherein a mean value of a thickness T of the exposed part is 4 to 30 µm.

6. A method of producing a joined body, the method comprising:
applying a Ag-Cu-Sn-based brazing material containing silver, copper, tin, and an active metal contained as TiH₂ to a main surface of a substrate;
laminating the silicon nitride substrate and a copper plate with interposing the Ag-Cu-Sn-based brazing material therebetween to obtain a multilayer body;
firing the multilayer body at a firing temperature of 750°C or higher for 10 minutes or longer; and
annealing the fired multilayer body at a temperature of 550°C or higher and lower than 750°C for 10 minutes or longer,
wherein the content of silver in the brazing material is 85% by mass or more,
wherein the content of tin in the brazing material is 0.5 to 5 parts by mass with respect to 100 parts by mass of the total of silver and copper,
wherein the content of TiH₂ in the brazing layer is 1 to 5 parts by mass with respect to 100 parts by mass of the total of silver and copper
wherein a mean value of a KAM value of a silver portion in the brazing layer obtained by EBSP method, as described in the description, using an orientation imaging microscopy is 0.55° or less,
wherein the KAM value is a kernel average misorientation value indicating an orientation difference between adjacent measurement points in a crystal grain, and EBSP is an electron back scattering pattern method.

7. The method of producing a joined body according to claim 6, wherein the multilayer body is held at a firing temperature of 750°C or higher for shorter than 3 hours, and
wherein the multilayer body is cooled from the firing temperature to a temperature lower than 750°C at a cooling rate of 1°C/min or more.

8. The method of producing a joined body according to claim 6 or 7,
wherein a mean value of a KAM value of copper contained in the copper plate obtained by EBSP method using an orientation imaging microscopy is 0.36° or less.

9. A method of producing a circuit board, comprising removing a part of a copper plate in the joined body obtained by the producing method according to any one of claims 6 to 8 to form a copper circuit board, thereby obtaining a circuit board.

10. The method of producing a circuit board according to claim 9, wherein the circuit board comprises an exposed part in which a brazing layer is exposed from an edge of the copper circuit board,
wherein a mean value of a length L of the exposed part is 20 µm or more, and
wherein a mean value of a thickness T of the brazing layer is 4 to 30 µm.

## Patentansprüche

1. Verbundkörper, bei dem ein Siliziumnitridsubstrat und eine Kupferplatte mit einer Hartlötschicht verbunden sind, die aus einem Hartlötmaterial auf Ag-Cu-Sn-Basis gebildet ist, enthaltend Silber, Kupfer, Zinn und ein als TiH₂ enthaltenes Aktivmetall,
wobei der Gehalt an Silber in der Hartlötschicht 85 Massen-% oder mehr beträgt,
wobei die Menge an Zinn in der Hartlötschicht 0,5 bis 5 Massenteile, bezogen auf 100 Massenteile der Gesamtmenge an Silber und Kupfer, beträgt, wobei der Gehalt an TiH₂ in der Hartlötschicht 1 bis 5 Massenteile, bezogen auf 100 Massenteile der Gesamtmenge an Silber und Kupfer, beträgt,
wobei ein Mittelwert eines KAM-Wertes des Silberanteils in der Hartlötschicht, der durch das EBSP-Verfahren, wie in der Beschreibung beschrieben, unter Verwendung einer Orientierungsabbildungsmikroskopie erhalten wird, 0,55° oder weniger beträgt, und
wobei der KAM-Wert ein mittlerer Kernfehlorientierungswert ist, der eine Orientierungsdifferenz zwischen benachbarten Messpunkten in einem Kristallkorn anzeigt, und EBSP ein Elektronenrückstreumusterverfahren ist.

2. Verbundkörper gemäß Anspruch 1,
wobei ein Mittelwert eines KAM-Wertes von Kupfer, das in der Kupferplatte enthalten ist, der durch das EBSP-Verfahren erhalten wird, 0,36° oder weniger beträgt.

3. Verbundkörper gemäß Anspruch 1 oder 2,
wobei ein Mittelwert einer Dicke T der Hartlötschicht 4 bis 30 µm beträgt.

4. Verbundkörper gemäß mindestens einem der Ansprüche 1 bis 3, wobei die Kupferplatte eine Kupferleiterplatte ist, und wobei der Verbundkörper eine Leiterplatte ist.

5. Verbundkörper gemäß Anspruch 4, wobei die Hartlötschicht einen freiliegenden Teil umfasst, der von einer Kante der Kupferleiterplatte freiliegt,
wobei ein Mittelwert der Länge L des freiliegenden Teils 20 µm oder mehr beträgt, und
wobei ein Mittelwert einer Dicke T des freigelegten Teils 4 bis 30 µm beträgt.

6. Verfahren zur Herstellung eines Verbundkörpers, wobei das Verfahren umfasst:
Aufbringen eines Hartlötmaterials auf Ag-Cu-Sn-Basis, enthaltend Silber, Kupfer, Zinn und ein als TiH₂ enthaltenes Aktivmetall, auf eine Hauptoberfläche eines Substrats;
Laminieren des Siliziumnitridsubstrats und einer Kupferplatte unter Zwischenfügen des Hartlötmaterials auf Ag-Cu-Sn-Basis, um einen Mehrschichtkörper zu erhalten;
Brennen des Mehrschichtkörpers bei einer Brenntemperatur von 750°C oder höher für 10 Minuten oder länger; und
Ausglühen des gebrannten Mehrschichtkörpers bei einer Temperatur von 550°C oder höher und niedriger als 750°C für 10 Minuten oder länger,
wobei der Gehalt an Silber in dem Hartlötmaterial 85 Massen-% oder mehr beträgt,
wobei der Gehalt an Zinn in dem Hartlötmaterial 0,5 bis 5 Massenteile, bezogen auf 100 Massenteile der Gesamtmenge an Silber und Kupfer, beträgt,
wobei der Gehalt an TiH₂ in der Hartlötschicht 1 bis 5 Masseteile, bezogen auf 100 Massenteile der Gesamtmenge an Silber und Kupfer, beträgt,
wobei ein Mittelwert eines KAM-Wertes eines Silberanteils in der Hartlötschicht, der durch das EBSP-Verfahren, wie in der Beschreibung beschrieben, unter Verwendung einer Orientierungsabbildungsmikroskopie erhalten wird, 0,55° oder weniger beträgt,
wobei der KAM-Wert ein mittlerer Kernfehlorientierungswert ist, der eine Orientierungsdifferenz zwischen benachbarten Messpunkten in einem Kristallkorn anzeigt, und EBSP ein Elektronenrückstreumusterverfahren ist.

7. Verfahren zur Herstellung eines Verbundkörpers gemäß Anspruch 6, wobei der Mehrschichtkörper bei einer Brenntemperatur von 750°C oder höher für weniger als 3 Stunden gehalten wird und
wobei der Mehrschichtkörper von der Brenntemperatur auf eine Temperatur von weniger als 750°C mit einer Abkühlungsrate von 1°C/min oder mehr abgekühlt wird.

8. Verfahren zur Herstellung eines Verbundkörpers gemäß Anspruch 6 oder 7,
wobei ein Mittelwert eines KAM-Wertes von Kupfer, das in der Kupferplatte enthalten ist, der durch das EBSP-Verfahren unter Verwendung einer Orientierungsabbildungsmikroskopie erhalten wird, 0,36° oder weniger beträgt.

9. Verfahren zur Herstellung einer Leiterplatte, umfassend das Entfernen eines Teils einer Kupferplatte in dem Verbundkörper, der durch das Herstellungsverfahren gemäß mindestens einem der Ansprüche 6 bis 8 erhalten wurde, um eine Kupferleiterplatte zu bilden, wodurch eine Leiterplatte erhalten wird.

10. Verfahren zur Herstellung einer Leiterplatte gemäß Anspruch 9, wobei die Leiterplatte einen freiliegenden Teil umfasst, in dem eine Hartlötschicht von einer Kante der Kupferleiterplatte freiliegt,
wobei ein Mittelwert einer Länge L des freiliegenden Teils 20 µm oder mehr beträgt, und
wobei ein Mittelwert einer Dicke T der Hartlötschicht 4 bis 30 µm beträgt.

## Revendications

1. Corps assemblé dans lequel un substrat en nitrure de silicium et une plaque de cuivre sont assemblés ensemble avec une couche de brasage formée d'un matériau de brasage à base d'Ag-Cu-Sn contenant de l'argent, du cuivre, de l'étain et un métal actif contenu sous forme de TiH₂,
dans lequel la teneur en argent dans la couche de brasage est de 85 % en masse ou plus,
dans lequel la quantité d'étain dans la couche de brasage est de 0,5 à 5 parties en masse par rapport à 100 parties en masse du total d'argent et de cuivre, dans lequel la teneur en TiH₂ dans la couche de brasage est de 1 à 5 parties en masse par rapport à 100 parties en masse du total d'argent et de cuivre,
dans lequel une valeur moyenne d'une valeur KAM d'une partie d'argent dans la couche de brasage obtenue par le procédé EBSP, tel que décrit dans la description, au moyen d'une microscopie d'imagerie d'orientation est de 0,55° ou moins, et
dans lequel la valeur KAM est une valeur moyenne de désorientation locale indiquant une différence d'orientation entre des points de mesure adjacents dans un grain cristallin, et l'EBSP est un procédé par motif de rétrodiffusion d'électrons.

2. Corps assemblé selon la revendication 1,
dans lequel une valeur moyenne d'une valeur KAM du cuivre contenu dans la plaque de cuivre obtenue par le procédé EBSP est de 0,36° ou moins.

3. Corps assemblé selon la revendication 1 ou la revendication 2,
dans lequel une valeur moyenne d'une épaisseur T de la couche de brasage est de 4 à 30 µm.

4. Corps assemblé selon l'une quelconque des revendications 1 à 3, dans lequel la plaque de cuivre est une carte de circuit imprimé en cuivre, et
dans lequel le corps assemblé est une carte de circuit imprimé.

5. Corps assemblé selon la revendication 4, dans lequel la couche de brasage comprend une partie exposée exposée à partir d'un bord de la carte de circuit imprimé en cuivre,
dans lequel une valeur moyenne d'une longueur L de la partie exposée est de 20 µm ou plus, et
dans lequel une valeur moyenne d'une épaisseur T de la partie exposée est de 4 à 30 µm.

6. Procédé de production d'un corps assemblé, le procédé comprenant :
l'application d'un matériau de brasage à base d'Ag-Cu-Sn contenant de l'argent, du cuivre, de l'étain et un métal actif contenu sous forme de TiH₂ sur une surface principale d'un substrat ;
la stratification du substrat en nitrure de silicium et d'une plaque de cuivre avec interposition du matériau de brasage à base d'Ag-Cu-Sn entre ceux-ci pour obtenir un corps multicouche ;
la cuisson du corps multicouche à une température de cuisson de 750 °C ou plus pendant 10 minutes ou plus ; et
le recuit du corps multicouche cuit à une température de 550 °C ou plus et inférieure à 750°C pendant 10 minutes ou plus,
dans lequel la teneur en argent dans le matériau de brasage est de 85 % en masse ou plus,
dans lequel la teneur en étain dans le matériau de brasage est de 0,5 à 5 parties en masse par rapport à 100 parties en masse du total d'argent et de cuivre,
dans lequel la teneur en TiH₂ dans la couche de brasage est de 1 à 5 parties en masse par rapport à 100 parties en masse du total d'argent et de cuivre,
dans lequel une valeur moyenne d'une valeur KAM d'une partie d'argent dans la couche de brasage obtenue par le procédé EBSP, tel que décrit dans la description, au moyen d'une microscopie d'imagerie d'orientation est de 0,55° ou moins,
dans lequel la valeur KAM est une valeur moyenne de désorientation locale indiquant une différence d'orientation entre des points de mesure adjacents dans un grain cristallin, et l'EBSP est un procédé par motif de rétrodiffusion d'électrons.

7. Procédé de production d'un corps assemblé selon la revendication 6, dans lequel le corps multicouche est maintenu à une température de cuisson de 750 °C ou plus pendant moins de 3 heures, et
dans lequel le corps multicouche est refroidi à partir de la température de cuisson jusqu'à une température inférieure à 750 °C à une vitesse de refroidissement de 1 °C/min ou plus.

8. Procédé de production d'un corps assemblé selon la revendication 6 ou la revendication 7,
dans lequel une valeur moyenne d'une valeur KAM du cuivre contenu dans la plaque de cuivre obtenue par le procédé EBSP au moyen d'une microscopie d'imagerie d'orientation est de 0,36° ou moins.

9. Procédé de production d'une carte de circuit imprimé, comprenant l'élimination d'une partie d'une plaque de cuivre dans le corps assemblé obtenu par le procédé de production selon l'une quelconque des revendications 6 à 8 pour former une carte de circuit imprimé en cuivre, pour ainsi obtenir une carte de circuit imprimé.

10. Procédé de production d'une carte de circuit imprimé selon la revendication 9, dans lequel la carte de circuit imprimé comprend une partie exposée dans laquelle une couche de brasage est exposée à partir d'un bord de la carte de circuit imprimé en cuivre,
dans lequel une valeur moyenne d'une longueur L de la partie exposée est de 20 µm ou plus, et
dans lequel une valeur moyenne d'une épaisseur T de la couche de brasage est de 4 à 30 µm.
